# EUROPÄISCHE PATENTANMELDUNG

(11) **EP 4 845 012 A1**
(43) Veröffentlichungstag der Anmeldung: **25.11.2026**
(21) Anmeldenummer: 25177719.9
(22) Anmeldetag: 20.05.2025
(51) Int. Cl.: H02M 3/335, H02M 1/00, H02M 1/08, H02M 1/32, H03K 17/605, H03K 17/61, H03K 17/689, H03K 17/691, B23K 9/10

(54) **VORRICHTUNG ZUR ERZEUGUNG EINES SCHWEISSSTROMS FÜR EIN SCHWEISSGERÄT MIT PELV-SIGNALSTROMKREIS SOWIE SCHWEISSGERÄT**

(71) Anmelder: EWM GmbH, 56271 Mündersbach (DE)
(72) Erfinder: SIEGERT, Levin, 57648 Unnau (DE); GIEBL, Stefan, 65618 Selters (Taunus) - Münster (DE)
(74) Vertreter: Cohausz & Florack

(57) **Zusammenfassung**

Die Erfindung betrifft eine Vorrichtung (350) zur Erzeugung eines Schweißstroms für ein Schweißgerät (100), insbesondere Lichtbogenschweißgerät, mit einer Leistungshalbleiter-Schaltung (206) umfassend ein oder mehrere Leistungshalbleiter-Schaltelemente (S1, S2, S3, S4) und mit einer Gate-Treiber-Schaltung (208), die ein oder mehrere Steuersignaleingänge (T1, T2, T3, T4) zum Empfang von elektrischen Steuersignalen und ein oder mehrere Treiberausgänge (TA1, TA2, TA3, TA4) zum elektrischen Ansteuern der ein oder mehreren Leistungshalbleiter-Schaltelemente (S1, S2, S3, S4) aufweist und dazu eingerichtet ist, die Leistungshalbleiter-Schaltelemente (S1, S2, S3, S4) abhängig von über die ein oder mehreren Steuersignaleingänge (T1, T2, T3, T4) empfangenen elektrischen Steuersignalen elektrisch anzusteuern, wobei die Gate-Treiber-Schaltung (208) so ausgebildet ist, dass die ein oder mehreren Steuersignaleingänge (T1, T2, T3, T4) von den ein oder mehreren Treiberausgängen (TA1, TA2, TA3, TA4) galvanisch getrennt sind, und wobei die ein oder mehreren Steuersignaleingänge (T1, T2, T3, T4) der Gate-Treiber-Schaltung (208) mit einem PELV-Signalstromkreis (PSSK) verbunden sind. Die Erfindung betrifft weiter ein Schweißgerät (100), insbesondere Lichtbogenschweißgerät (100), aufweisend eine solche Vorrichtung (350).

## Beschreibung

Die vorliegende Erfindung betrifft eine Vorrichtung zur Erzeugung eines Schweißstroms für ein Schweißgerät, insbesondere Lichtbogenschweißgerät, mit einer Leistungshalbleiter-Schaltung umfassend ein oder mehrere Leistungshalbleiter-Schaltelemente und mit einer Gate-Treiber-Schaltung, die ein oder mehrere Steuersignaleingänge zum Empfang von elektrischen Steuersignalen und ein oder mehrere Treiberausgänge zum elektrischen Ansteuern der ein oder mehreren Leistungshalbleiter-Schaltelemente aufweist und dazu eingerichtet ist, die Leistungshalbleiter-Schaltelemente abhängig von über die ein oder mehreren Steuersignaleingänge empfangenen elektrischen Steuersignalen elektrisch anzusteuern, wobei die Gate-Treiber-Schaltung so ausgebildet ist, dass die ein oder mehreren Steuersignaleingänge von den ein oder mehreren Treiberausgängen galvanisch getrennt sind. Die vorliegende Erfindung betrifft weiter ein Schweißgerät, insbesondere Lichtbogenschweißgerät, mit einer solchen Vorrichtung.

Aus dem Stand der Technik sind Lichtbogenschweißstromquellen mit Hochleistungs-Schaltnetzteilen (sog. Inverter) bekannt.

Eine aus Sicherheitsgesichtspunkten besonders kritische Komponente derartiger Schaltnetzteile ist die Isolierung der Ansteuertreiberstufe zur Übertragung der Gate-Ansteuerimpulse vom Steuerstromkreis, der in der Regel auf Sicherheitskleinspannungs-Potential (SELV-Stromkreis) liegt, über die galvanische Trennung hinweg zu den Leistungstransistoren, die sich im Versorgungs-Stromkreis auf Primär-Potential befinden. Die galvanische Trennung wird daher mit doppelter oder verstärkter Isolierung ausgeführt.

Weiter besteht bei Schweißgeräten - anders als bei fast allen anderen elektrischen Betriebsmitteln mit einem Schaltnetzteil - die Anforderung, dass Schweißgeräte gemäß der Produktnorm IEC 60974-1 so ausgelegt werden müssen, dass sie auch in einer Umgebung mit Verschmutzungsgrad 3 sicher betrieben werden können. Dadurch ergeben sich höhere Anforderungen an Luft- und Kriechstrecken. Dies erhöht auch den Aufwand, um die Betriebssicherheit des Schaltnetzteils sicherzustellen.

Vor diesem Hintergrund liegt der vorliegenden Erfindung die Aufgabe zu Grunde, eine Vorrichtung zur Erzeugung eines Schweißstroms für ein Schweißgerät, insbesondere Lichtbogenschweißgerät, zur Verfügung zu stellen, die einen sichereren Betrieb ermöglicht und/oder günstiger herstellbar ist. Weiter liegt der vorliegenden Erfindung die Aufgabe zu Grunde, ein Schweißgerät, insbesondere Lichtbogenschweißgerät, mit einer solchen Vorrichtung zur Verfügung zu stellen.

Die zuvor genannte Aufgabe wird erfindungsgemäß gelöst durch eine Vorrichtung zur Erzeugung eines Schweißstroms für ein Schweißgerät, insbesondere Lichtbogenschweißgerät, mit einer Leistungshalbleiter-Schaltung umfassend ein oder mehrere Leistungshalbleiter-Schaltelemente und mit einer Gate-Treiber-Schaltung, die ein oder mehrere Steuersignaleingänge zum Empfang von elektrischen Steuersignalen und ein oder mehrere Treiberausgänge zum elektrischen Ansteuern der ein oder mehreren Leistungshalbleiter-Schaltelemente aufweist und dazu eingerichtet ist, die Leistungshalbleiter-Schaltelemente abhängig von über die ein oder mehreren Steuersignaleingänge empfangenen elektrischen Steuersignalen elektrisch anzusteuern, wobei die Gate-Treiber-Schaltung so ausgebildet ist, dass die ein oder mehreren Steuersignaleingänge von den ein oder mehreren Treiberausgängen galvanisch getrennt sind, und wobei die ein oder mehreren Steuersignaleingänge der Gate-Treiber-Schaltung mit einem PELV-Signalstromkreis verbunden sind.

Durch einen solchen PELV-Signalstromkreis wird erreicht, dass auch bei dem Auftreten eines einzelnen Fehlers, beispielsweise bei einem Versagen der galvanischen Trennung in der Gate-Treiber-Schaltung, das Auftreten von gefährlichen Spannungen am PELV-Signalstromkreis und der Steuerelektronik verhindert wird, so dass dieser Bereich der Gesamtschaltung weiterhin gefahrlos berührt werden kann. Auf diese Weise wird die Bedienungssicherheit erhöht, und insbesondere ein normkonformer und sicherer Betrieb der Schaltung möglich.

Durch das Vorsehen eines PELV-Signalstromkreises in Kombination mit der galvanischen Trennung in der Gate-Treiber-Schaltung wird insbesondere eine doppelte Isolierung gegenüber dem Steuerstromkreis erreicht, so dass die Betriebssicherheit bei Auftreten eines Einfachfehlers gewährleistet ist. Darüber hinaus können durch diese Absicherung geringere Anforderungen an die Isolierung der Gate-Treiber-Schaltung, insbesondere deren Kriechstrecken, gestellt werden, wodurch sich der notwendige technische Aufwand zur Sicherstellung der Gerätesicherheit reduziert. Beispielsweise brauchen in der Gate-Treiber-Schaltung auf diese Weise die jeweilige galvanische Trennung lediglich für eine Basis-Isolierung anstelle einer doppelten oder verstärkten Isolierung bemessen werden.

Unter einem PELV-Stromkreis, wie zum Beispiel in PELV-Signalstromkreis, wird vorliegend insbesondere ein PELV-Stromkreis gemäß EN 60208-1:2018 verstanden. Weiter wird unter einem PE-Schutzleiter vorliegend insbesondere ein Schutzleiter gemäß IEC 60204-1 verstanden.

Die Vorrichtung weist eine Leistungshalbleiter-Schaltung mit ein oder mehreren Leistungshalbleiter-Schaltelementen auf. Die Leistungshalbleiter-Schaltung kann beispielsweise eine Vollbrückenwandler-Schaltung, Halbbrückenwandler-Schaltung, Sperrwandler-Schaltung, Durchflusswandler-Schaltung und/oder LLC-WandlerSchaltung umfassen.

Ein für die Leistungshalbleiter-Schaltung verwendetes Leistungshalbleiter-Schaltelement kann insbesondere einen Transistor, vorzugsweise einen Feldeffekttransistor, wie zum Beispiel MOSFET, JFET oder HEMT, einen Bipolartransistor oder einen IGBT, umfassen. Das Leistungshalbleiter-Schaltelement kann weiter eine antiparallel zum Transistor geschaltete Diode aufweisen.

Ein oder mehrere der für die Leistungshalbleiter-Schaltung verwendeten Leistungshalbleiter-Schaltelemente können auch mehrere, insbesondere parallel und/oder in Reihe geschaltete, Transistoren umfassen. Die parallel und/oder in Reihe geschalteten Transistoren können Bipolartransistoren, Feldeffekttransistoren und/oder IGBTs umfassen, unabhängig von deren Halbleitermaterialien. Beispielsweise kann ein solches Leistungshalbleiter-Schaltelement eine Kaskodenschaltung mit zwei oder mehreren Transistoren umfassen. Weiterhin kann ein solches Leistungshalbleiter-Schaltelement einen emittergeschalteten Bipolartransistor (ESBT: emitter switched bipolar transistor), d.h. einen Bipolartransistor in Kombination mit einem MOSFET, umfassen.

Die Vorrichtung weist weiter eine Gate-Treiber-Schaltung auf.

Der Begriff Gate, wie in Gate-Treiber-Schaltung, wird vorliegend ungeachtet der Art der tatsächlich in den Leistungshalbleiter-Schaltelementen verwendeten Transistoren verwendet. So kann unter Gate vorliegend sowohl der Gate-Anschluss eines Feldeffekttransistors, zum Beispiel eines MOSFET, JFET, oder eines IGBTs als auch der Basis-Anschluss eines Bipolartransistors verstanden werden.

Die Gate-Treiber-Schaltung dient zur Ansteuerung der ein oder mehreren Leistungshalbleiter-Schaltelemente der Leistungshalbleiter-Schaltung. Zu diesem Zweck weist die Gate-Treiber-Schaltung ein oder mehrere Steuersignaleingänge zum Empfang von elektrischen Steuersignalen auf.

Die ein oder mehreren Steuersignaleingänge sind vorzugsweise zum Anschließen ein oder mehrerer Steuersignalleitungen, insbesondere einer jeweiligen Steuersignalleitung, ausgebildet. Zu diesem Zweck können beispielsweise ein oder mehrere mechanische Verbinderteile, wie Steckverbinderteile, zum mechanischen und elektrischen Verbinden mit den Steuersignalleitungen, beispielsweise über korrespondierende Verbinderteile, vorgesehen sein. Es ist auch denkbar, dass die ein oder mehreren Steuersignaleingänge fest mit einer jeweiligen Steuersignalleitung verbunden, beispielsweise verlötet, werden können oder verlötet sind. Zu diesem Zweck kann für die einzelnen Steuersignaleingänge beispielsweise eine jeweilige Lötfahne vorgesehen sein.

Es kann insbesondere für jedes der von der Gate-Treiber-Schaltung angesteuerten Leistungshalbleiter-Schaltelemente ein jeweiliger Steuersignaleingang vorgesehen sein. Die Steuersignalleitungen können beispielsweise in ein oder mehreren mehradrigen Kabeln untergebracht sein und die ein oder mehreren Steuersignaleingänge können insbesondere zum Anschließen von ein oder mehreren mehradrigen Kabeln ausgebildet sein.

Beispielsweise kann die Vorrichtung eine Steuerelektronik aufweisen, die die Steuersignale zur Steuerung der Leistungshalbleiter-Schaltung erzeugt und die zur Übermittelung der Steuersignale mit den ein oder mehreren Steuersignaleingängen verbunden ist. Die Steuerelektronik kann insbesondere mindestens einen Mikroprozessor, vorzugsweise einen Mikrocontroller, umfassen. Die Steuerelektronik ist insbesondere dazu eingerichtet, Steuersignale an die ein oder mehreren Steuersignaleingänge zu übermitteln.

Die Gate-Treiber-Schaltung weist weiter ein oder mehrere Treiberausgänge zum elektrischen Ansteuern der ein oder mehreren Leistungshalbleiter-Schaltelemente auf. Insbesondere kann je Leistungshalbleiter-Schaltelement ein jeweiliger Treiberausgang vorgesehen sein, der mit einem Gate-Anschluss eines jeweiligen der Leistungshalbleiter-Schaltelemente elektrisch leitend verbunden ist. Weiter kann insbesondere je Treiberausgang mindestens ein Steuersignaleingang vorgesehen sein.

Die Gate-Treiber-Schaltung ist dazu eingerichtet, die Leistungshalbleiter-Schaltelemente abhängig von über die ein oder mehreren Steuersignaleingänge empfangenen elektrischen Steuersignalen elektrisch anzusteuern. Ist beispielsweise für jedes der von der Gate-Treiber-Schaltung angesteuerten Leistungshalbleiter-Schaltelemente ein jeweiliger Steuersignaleingang vorgesehen, so kann die Gate-Treiber-Schaltung beispielsweise dazu eingerichtet sein, die einzelnen Leistungshalbleiter-Schaltelemente über die ein oder mehreren Treiberausgänge, insbesondere über einen jeweiligen der Treiberausgänge, entsprechend der über den dem jeweiligen Leistungshalbleiter-Schaltelement zugeordneten Steuersignaleingang empfangenen Steuersignale anzusteuern.

Die Gate-Treiber-Schaltung kann insbesondere ein oder mehrere Gate-Treiber aufweisen, die jeweils dazu eingerichtet sind, die Ansteuerung von mindestens einem der ein oder mehreren Leistungshalbleiter-Schaltelemente über einen der Treiberausgänge abhängig von über mindestens einen der ein oder mehreren Steuersignaleingänge erhaltenen Steuersignalen zu bewirken.

Die Gate-Treiber-Schaltung ist so ausgebildet, dass die ein oder mehreren Steuersignaleingänge von den ein oder mehreren Treiberausgängen galvanisch getrennt sind. Zu diesem Zweck weisen vorzugsweise die Gate-Treiber der Gate-Treiber-Schaltung eine galvanische Trennung auf. Beispielsweise können die Gate-Treiber-Schaltung bzw. die ein oder mehreren Gate-Treiber der Gate-Treiber-Schaltung ein oder mehrere Signalisolatoren zur galvanisch getrennten Übertragung von Steuersignalen von den ein oder mehreren Steuersignaleingängen zu den ein oder mehreren Treiberausgängen aufweisen. Die Signalisolatoren können beispielsweise ein oder mehrere Spannungswandler mit galvanischer Trennung aufweisen.

Umfasst die Gate-Treiber-Schaltung zudem ein oder mehrere Gate-Treiber-Spannungsversorgungsschaltungen mit einer jeweiligen Eingangsseite und einer jeweiligen Ausgangsseite, insbesondere zur Bereitstellung der Spannung oder des Stroms zur Ansteuerung der Leistungshalbleiter-Schaltelemente auf der Ausgangsseite, so umfassen die Gate-Treiber-Spannungsversorgungsschaltungen zudem vorzugsweise eine galvanische Trennung, insbesondere zwischen deren Eingangsseite und Ausgangsseite. Zu diesem Zweck können die ein oder mehreren Gate-Treiber-Spannungsversorgungsschaltungen insbesondere ein oder mehrere Spannungswandler, insbesondere DC/DC-Wandler, mit galvanischer Trennung aufweisen. Auf diese Weise kann aufseiten eines Treiberausgangs auch eine galvanisch getrennte Spannungsversorgung bereitgestellt werden. Dadurch kann sowohl hinsichtlich der Signalübertragung, insbesondere über einen jeweiligen Gate-Treiber, als auch hinsichtlich der Spannungsversorgung über eine zugehörige Gate-Treiber-Spannungsversorgungsschaltung eine galvanische Trennung des betreffenden Steuersignaleingangs von dem betreffenden Treiberausgang erreicht werden.

Durch die galvanische Trennung der ein oder mehreren Steuersignaleingänge von den ein oder mehreren Treiberausgängen kann eine Isolierung zwischen dem Steuerstromkreis und dem Primär-Potential erreicht werden. Die galvanische Trennung der ein oder mehreren Steuersignaleingänge von den ein oder mehreren Treiberausgängen kann mit einer doppelten oder verstärkten Isolierung oder alternativ mit lediglich einer Basis-Isolierung ausgeführt werden.

Vorzugsweise sind weiter auch die ein oder mehreren Treiberausgänge galvanisch voneinander getrennt, insbesondere mit mindestens einer Funktionsisolierung. Auf diese Weise wird eine für die Funktion wichtige Isolierung zwischen den unterschiedlichen Bezugspotentialen der verschiedenen Leistungshalbleiter-Schaltelemente erreicht.

Die ein oder mehreren Steuersignaleingänge der Gate-Treiber-Schaltung sind mit einem PELV-Signalstromkreis verbunden. Der PELV-Signalstromkreis, vorzugsweise eine Basispotentialleitung des PELV-Signalstromkreises, ist insbesondere mit einem PE-Schutzleiter oder mit einem PE-Anschluss zum Anschließen an einen PE-Schutzleiter verbunden. Bei dem PE-Schutzleiter kann es sich insbesondere um den PE-Schutzleiter der Vorrichtung handeln. Der PE-Anschluss kann insbesondere zum Anschließen an den PE-Schutzleiter eines Schweißgerät, insbesondere Lichtbogenschweißgeräts, vorgesehen sein, in das die Vorrichtung integriert werden oder sein kann.

Die Leitungen in der Gate-Treiber-Schaltung zum PE-Anschluss und/oder zum PE-Schutzleiter sind vorzugsweise derart dimensioniert, um eine Schutzerdung des PELV-Signalstromkreises bewirken zu können. Insbesondere sind diese Leitungen vorzugsweise derart ausgelegt, um in einem Fehlerfall in der galvanischen Trennung der ein oder mehreren Steuersignaleingänge von den ein oder mehreren Treiberausgängen den an den ein oder mehreren Treiberausgängen fließenden Strömen entsprechende Fehlerströme, zum Beispiel Stoßströme von ca. 10 kA, zum PE-Anschluss oder PE-Schutzleiter tragen zu können, insbesondere zum PE-Schutzleiter ableiten zu können.

Die zuvor genannte Aufgabe wird erfindungsgemäß weiterhin gelöst durch ein Schweißgerät, insbesondere Lichtbogenschweißgerät, das die zuvor beschriebene Vorrichtung zur Erzeugung eines Schweißstroms oder eine Ausführungsform davon umfasst. Bei dem Schweißgerät kann es sich beispielsweise um ein Schweißgerät zum Metallschutzgasschweißen mit abschmelzender Elektrode (z.B. MIG- oder MAG-Schweißen), um ein Schweißgerät zum Schweißen von Stabelektroden (sog. E-Hand-Schweißen) oder um ein Schweißgerät zum Schweißen mit nicht-abschmelzender Elektrode, insbesondere Wolfram-Inertgas-Schweißen (WIG-Schweißen), handeln.

Das Schweißgerät, insbesondere Lichtbogenschweißgerät, umfasst insbesondere eine Schweißstromquelle mit einem Schweißstromausgang zur Bereitstellung eines Schweißstromes. Die Schweißstromquelle umfasst vorzugsweise die Vorrichtung zur Erzeugung eines Schweißstroms, die in der Schweißstromquelle vorzugsweise derart verschaltet ist, um den Schweißstrom über den Schweißstromausgang der Schweißstromquelle bereitzustellen. Insbesondere kann die Vorrichtung zur Erzeugung eines Schweißstroms in einem Gehäuse der Schweißstromquelle untergebracht sein. Darüber hinaus kann die Schweißstromquelle zum Beispiel eine Nutzerschnittstelle aufweisen, über die ein Nutzer Informationen ablesen und/oder Steuerbefehle eingeben kann.

Der Schweißstromausgang umfasst vorzugsweise mindestens zwei Anschlüsse, insbesondere einen Anschluss zum Anschließen eines Schweißbrenners und einen Anschluss zum Anschließen einer Werkstückleitung.

Zum Schweißen kann an die Schweißstromquelle weitere Peripherie angeschlossen werden, beispielsweise eine Drahtvorschubvorrichtung (z.B. bei einem MIG/MAG-Schweißgerät) und/oder ein Schweißbrenner. Die Peripherie der Schweißstromquelle kann als Teil des Schweißgeräts angesehen werden. Das gegenständliche Schweißgerät kann jedoch zum Beispiel auch lediglich aus der Schweißstromquelle bestehen, die dann zum Beispiel mit separater Peripherie betrieben werden kann.

Im Folgenden werden verschiedene Ausführungsformen der Vorrichtung und des Schweißgeräts, insbesondere Lichtbogenschweißgeräts, beschrieben, wobei die einzelnen Ausführungsformen jeweils unabhängig voneinander für die Vorrichtung und das Lichtbogenschweißgerät gelten. Darüber hinaus können die einzelnen Ausführungsformen beliebig miteinander kombiniert werden.

Bei einer Ausführungsform ist der PELV-Signalstromkreis weiter über eine Signal-Entkoppelungsschaltung mit einem Steuerstromkreis gekoppelt, so dass Steuersignale von dem Steuerstromkreis auf den PELV-Signalstromkreis übertragen werden können, wobei die Signal-Entkoppelungsschaltung den PELV-Signalstromkreis und den Steuerstromkreis voneinander galvanisch trennt. Die Entkoppelungsschaltung umfasst vorzugsweise einen oder mehrere Signalisolatoren zur galvanisch getrennten Übertragung von Steuersignalen.

Die Signal-Entkoppelungsschaltung kann insbesondere zwischen einer Steuerelektronik zur Erzeugung der Steuersignale und den ein oder mehreren Steuersignaleingängen der Gate-Treiber-Schaltung geschaltet sein, so dass die Signal-Entkoppelungsschaltung die Steuerelektronik von den ein oder mehreren Steuersignaleingängen galvanisch trennt.

Die Verschaltung der Signal-Entkoppelungsschaltung mit dem Steuersignaleingang der Gate-Treiber-Schaltung umfasst weiter vorzugsweise eine Schutzerdung. Durch die galvanische Trennung in der Gate-Treiber-Schaltung sowie die galvanische Trennung in der Signal-Entkoppelungsschaltung wird auf diese Weise zwischen der Signal-Entkoppelungsschaltung, insbesondere deren Ausgang, und der Gate-Treiber-Schaltung, insbesondere deren ein oder mehreren Steuersignaleingängen, ein Schutzleiter-geerdeter Stromkreis (PELV-Stromkreis) für die Steuersignale (d.h. ein PELV-Signalstromkreis) bewirkt.

Bei einer Ausführungsform weist die Gate-Treiber-Schaltung ein oder mehrere Gate-Treiber auf, die jeweils dazu eingerichtet sind, die Ansteuerung von mindestens einem der ein oder mehreren Leistungshalbleiter-Schaltelemente über einen der Treiberausgänge abhängig von über mindestens einen der ein oder mehreren Steuersignaleingänge erhaltenen Steuersignalen zu bewirken. Insbesondere kann je Leistungshalbleiter-Schaltelement ein jeweiliger Gate-Treiber vorgesehen sein.

Vorzugsweise weisen die ein oder mehreren Gate-Treiber einen jeweiligen Signalisolator zur galvanisch getrennten Übertragung von über einen jeweiligen Steuersignaleingang erhaltenen Steuersignalen auf und sind dazu eingerichtet, die zur Ansteuerung eines jeweiligen der Leistungshalbleiter-Schaltelemente verwendete elektrische Leistung zumindest teilweise, vorzugsweise überwiegend, insbesondere praktisch vollständig, über eine vom Signalisolator separate Gate-Treiber-Spannungsversorgungsschaltung zu erhalten. Die vom Signalisolator separate Gate-Treiber-Spannungsversorgungsschaltung versorgt demnach insbesondere den Teil eines jeweiligen Gate-Treibers auf Seiten des betreffenden Treiberausgangs. Auf diese Weise erfolgt die Steuersignalübertragung separat von der Bereitstellung der zur Ansteuerung der Leistungshalbleiter-Schaltelemente erforderlichen Leistung, insbesondere des dafür erforderlichen Stroms.

Die Ansteuerung von Leistungshalbleiter-Schaltelementen erfordert typischerweise recht hohe Gateströme. Indem diese Ströme bzw. die Schaltleistung separat von der Signalübertragung durch die Gate-Treiber-Spannungsversorgungsschaltung bereitgestellt werden, kann die Signalübertragung auf geringe Ströme bzw. geringe Leistung beschränkt werden, wodurch höhere Schaltfrequenzen bzw. steilere Schaltflanken ermöglicht werden.

Bei einer Ausführungsform weist die Vorrichtung ein oder mehrere Gate-Treiber-Spannungsversorgungsschaltungen auf. Die ein oder mehreren Gate-Treiber-Spannungsversorgungsschaltungen dienen dazu, die Spannung bzw. den Strom zur Ansteuerung der Leistungshalbleiter-Schaltelemente durch die Gate-Treiber-Schaltung bereit zu stellen. Zu diesem Zweck weisen die ein oder mehreren Gate-Treiber-Spannungsversorgungsschaltungen vorzugsweise jeweils eine Eingangsseite zur Versorgung der jeweiligen Gate-Treiber-Spannungsversorgungsschaltung mit einer Eingangsspannung und/oder einem Eingangsstrom sowie eine Ausgangsseite zur Bereitstellung der Spannung und/oder des Stroms zur Ansteuerung der Leistungshalbleiter-Schaltelemente auf.

Die Gate-Treiber-Spannungsversorgungsschaltungen können auf diese Weise die zum Ansteuern der Leistungshalbleiter-Schaltelemente erforderliche Leistung separat von der Übertragung der Steuersignale bereitstellen und somit insbesondere die Gate-Treiber versorgen. Damit stellt eine solche Gate-Treiber-Spannungsversorgungsschaltung insbesondere eine Ausgestaltung einer separat vom Signalisolator vorgesehenen Gate-Treiber-Spannungsversorgungsschaltung dar, die die zur Ansteuerung eines betreffenden Leistungshalbleiter-Schaltelements verwendete elektrische Leistung zumindest teilweise, vorzugsweise überwiegend, insbesondere praktisch vollständig, bereitstellt.

Die ein oder mehreren Gate-Treiber-Spannungsversorgungsschaltungen können beispielsweise jeweils einen oder mehrere DC/DC-Wandler, vorzugsweise DC/DC-Wandler mit galvanischer Trennung, umfassen, die vorzugsweise zwischen die Eingangsseite und die Ausgangsseite der betreffenden Gate-Treiber-Spannungsversorgungsschaltung geschaltet sind. Beispielsweise kann je Leistungshalbleiter-Schaltelement eine Gate-Treiber-Spannungsversorgungsschaltung vorgesehen sein, die die Spannung bzw. den Strom zur Ansteuerung des betreffenden Leistungshalbleiter-Schaltelements durch die Gate-Treiber-Schaltung bereitstellt. Es ist jedoch auch denkbar, dass für mehrere Leistungshalbleiter-Schaltelemente eine gemeinsame Gate-Treiber-Spannungsversorgungsschaltung vorgesehen ist.

Die ein oder mehreren Gate-Treiber-Spannungsversorgungsschaltungen umfassen vorzugsweise jeweils eine galvanische Entkoppelung, insbesondere zwischen der Eingangsseite und der Ausgangsseite der betreffenden Gate-Treiber-Spannungsversorgungsschaltung. Auf diese Weise kann das am Gate anliegende Potential, insbesondere Primär-Potential, vom Potential einer die Gate-Treiber-Spannungsversorgungsschaltungen versorgenden Spannungsquelle, insbesondere Gate-Treiber-Spannungsquelle, und/oder vom Potential der Steuerelektronik galvanisch getrennt werden. Sind mehrere Gate-Treiber-Spannungsversorgungsschaltungen vorgesehen, sind vorzugsweise deren jeweilige Ausgangsseiten galvanisch voneinander getrennt.

Die jeweilige Eingangsseite der ein oder mehreren Gate-Treiber-Spannungsversorgungsschaltungen kann zum Beispiel an einem SELV-Stromkreis angeschlossen sein. In diesem Fall weist die Gate-Treiber-Spannungsversorgungsschaltung, insbesondere ein DC/DC-Wandler der Gate-Treiber-Spannungsversorgungsschaltung, vorzugsweise eine doppelte oder verstärkte Isolierung auf.

Weiterhin kann die jeweilige Eingangsseite der ein oder mehreren Gate-Treiber-Spannungsversorgungsschaltungen zum Beispiel auch an einem PELV-Stromkreis angeschlossen sein. In diesem Fall kann die Gate-Treiber-Spannungsversorgungsschaltung, insbesondere ein DC/DC-Wandler der Gate-Treiber-Spannungsversorgungsschaltung, beispielsweise lediglich eine Basis-Isolierung aufweisen. Auf diese Weise können die Kosten für die Gate-Treiber-Spannungsversorgungsschaltung reduziert werden.

Weiterhin ist es denkbar, dass die jeweilige Eingangsseite der ein oder mehreren Gate-Treiber-Spannungsversorgungsschaltungen an einen Stromkreis auf Primärpotential angeschlossen ist. In diesem Fall kann die Gate-Treiber-Spannungsversorgungsschaltung, insbesondere ein DC/DC-Wandler der Gate-Treiber-Spannungsversorgungsschaltung, beispielsweise lediglich eine Funktions-Isolierung aufweisen. Auf diese Weise können die Kosten für die Gate-Treiber-Spannungsversorgungsschaltung reduziert werden. Anstelle eines DC/DC-Wandlers kann die Gate-Treiber-Spannungsversorgungsschaltung bei dieser Ausgestaltung beispielsweise eine Bootstrap-Schaltung aufweisen.

Es ist weiterhin denkbar, dass die jeweilige Eingangsseite der ein oder mehreren Gate-Treiber-Spannungsversorgungsschaltungen durch eine gesonderte Spannungsversorgung versorgt wird, beispielsweise durch eine Batterie, beispielsweise eine wiederaufladbare Batterie (Akkumulator), oder durch eine Solarzelle.

Bei einer Ausführungsform sind die ein oder mehreren Gate-Treiber-Spannungsversorgungsschaltungen mit einem PELV-Versorgungsstromkreis verbunden. Insbesondere kann der PELV-Versorgungsstromkreis über eine Versorgungs-Entkoppelungsschaltung mit einer Gate-Treiber-Spannungsquelle gekoppelt sein, wobei die Versorgungs-Entkoppelungsschaltung den PELV-Versorgungsstromkreis und die Gate-Treiber-Spannungsquelle voneinander galvanisch trennt. Die Versorgungs-Entkoppelungsschaltung weist vorzugsweise einen Spannungswandler, insbesondere DC/DC-Wandler, mit galvanischer Trennung auf. Der Spannungswandler mit galvanischer Trennung kann insbesondere einen Transformator oder eine gekoppelte Speicherdrossel aufweisen.

Der Spannungswandler mit galvanischer Trennung kann grundsätzlich aus einem beliebigen Stromkreis versorgt werden. Insbesondere kann der Spannungswandler mit galvanischer Trennung über den Steuerstromkreis bzw. aus einer Gate-Treiber-Spannungsquelle auf dem gleichen Potential wie der Steuerstromkreis versorgt werden. Dies ist jedoch nicht notwendig.

Die Verschaltung der Versorgungs-Entkoppelungsschaltung mit den ein oder mehreren Gate-Treiber-Spannungsversorgungsschaltungen umfasst weiter vorzugsweise eine Schutzerdung. Durch die vorzugsweise vorgesehene galvanische Trennung in den ein oder mehreren Gate-Treiber-Spannungsversorgungsschaltungen sowie die galvanische Trennung in der Versorgungs-Entkoppelungsschaltung wird auf diese Weise zwischen der Versorgungs-Entkoppelungsschaltung, insbesondere deren Ausgang, und den ein oder mehreren Gate-Treiber-Spannungsversorgungsschaltungen, ein Schutzleiter-geerdeter Stromkreis (PELV-Stromkreis) für die Spannungsversorgung (d.h. ein PELV-Versorgungsstromkreis) bewirkt.

Durch einen solchen PELV-Versorgungsstromkreis wird erreicht, dass auch bei dem Auftreten eines einzelnen Fehlers, beispielsweise bei einem Versagen der galvanischen Trennung in einer Gate-Treiber-Spannungsversorgungsschaltung, das Auftreten von gefährlichen Spannungen am PELV-Versorgungsstromkreis verhindert wird, so dass dieser Bereich der Gesamtschaltung weiterhin gefahrlos berührt werden kann. Auf diese Weise wird die Bedienungssicherheit erhöht, und insbesondere ein normkonformer und sicherer Betrieb der Schaltung möglich.

Durch das Vorsehen eines PELV-Versorgungsstromkreises in Kombination mit der galvanischen Trennung in der Gate-Treiber-Schaltung bzw. den ein oder mehreren Gate-Treiber-Stromversorgungsschaltungen wird insbesondere eine doppelte Isolierung gegenüber einer Gate-Treiber-Spannungsquelle erreicht, so dass die Betriebssicherheit bei Auftreten eines Einfachfehlers gewährleistet ist. Darüber hinaus können durch diese Absicherung geringere Anforderungen an die Isolierung der Gate-Treiber-Spannungsversorgungsschaltungen, insbesondere deren Kriechstrecken, gestellt werden, wodurch sich der notwendige technische Aufwand zur Sicherstellung der Gerätesicherheit reduziert. Beispielsweise brauchen in den Gate-Treiber-Spannungsversorgungsschaltungen auf diese Weise die jeweilige galvanische Trennung lediglich für eine Basis-Isolierung anstelle einer doppelten oder verstärkten Isolierung bemessen werden.

Unter einem PELV-Stromkreis, wie zum Beispiel in PELV-Signalstromkreis bzw. PELV-Versorgungsstromkreis, wird vorliegend insbesondere ein PELV-Stromkreis gemäß EN 60208-1:2018 verstanden. Weiter wird unter einem PE-Schutzleiter vorliegend insbesondere ein Schutzleiter gemäß IEC 60204-1 verstanden.

Der PELV-Versorgungsstromkreis, vorzugsweise eine Basispotentialleitung des PELV-Versorgungsstromkreises, ist insbesondere mit einem PE-Schutzleiter oder mit einem PE-Anschluss zum Anschließen an einen PE-Schutzleiter verbunden. Bei dem PE-Schutzleiter kann es sich insbesondere um den PE-Schutzleiter der Vorrichtung handeln. Der PE-Anschluss kann insbesondere zum Anschließen an den PE-Schutzleiter eines Schweißgeräts, insbesondere Lichtbogenschweißgeräts, vorgesehen sein, in das die Vorrichtung integriert werden oder sein kann.

Die Leitungen in der ein oder mehreren Gate-Treiber-Spannungsversorgungsschaltungen zum PE-Anschluss und/oder zum PE-Schutzleiter sind vorzugsweise derart dimensioniert, um eine Schutzerdung des PELV-Versorgungsstromkreises bewirken zu können. Insbesondere sind diese Leitungen vorzugsweise derart ausgelegt, um in einem Fehlerfall in der galvanischen Trennung in einem oder mehreren der Gate-Treiber-Spannungsversorgungsschaltungen den zur Ansteuerung des jeweiligen Leistungshalbleiter-Schaltelements fließenden Strömen entsprechende Fehlerströme, zum Beispiel Stoßströme von ca. 10 kA, zum PE-Anschluss oder PE-Schutzleiter tragen zu können, insbesondere zum PE-Schutzleiter ableiten zu können.

Der PELV-Signalstromkreis und der PELV-Versorgungsstromkreis können elektrisch miteinander verbunden sein, d.h. es kann sich um denselben PELV-Stromkreis handeln.

Bei einer Ausführungsform weisen die ein oder mehreren Gate-Treiber einen jeweiligen Ansteuerübertrager zur galvanisch getrennten Übertragung von über einen jeweiligen Steuersignaleingang erhaltenen Steuersignalen auf und sind dazu eingerichtet, die zur Ansteuerung eines jeweiligen der Leistungshalbleiter-Schaltelemente verwendete elektrische Leistung über die Ansteuerübertrager bereitzustellen. Auf diese Weise kann eine Potentialtrennung zwischen den Steuersignaleingängen und den Treiberausgängen erreicht werden. Die Anzahl der Ansteuerübertrager kann, muss jedoch nicht zwingend der Anzahl der Leistungshalbleiter-Schaltelemente entsprechen. Beispielsweise ist es denkbar, dass ein Ansteuerübertrager auch zwei oder mehr der Leistungshalbleiter-Schaltelemente ansteuern kann.

Ein solcher Ansteuerüberträger umfasst insbesondere zwei oder mehr über einen Magnetwerkstoff gekoppelte Wicklungen, die zumindest teilweise elektrisch voneinander isoliert sind. Beispielsweise kann es sich dabei um einen Ringkern mit einer Steuersignaleingangs-seitigen Primär- und einer Treiberausgangs-seitigen Sekundärwicklung handeln. Ein solcher Ansteuerüberträger erlaubt eine kombinierte Übertragung des Steuersignals zusammen mit der zur Ansteuerung der ein oder mehreren betreffenden Leistungshalbleiter-Schaltelemente erforderlichen Leistung.

Zusätzlich oder alternativ kann auch die optionale Signal-Entkoppelungsschaltung ein oder mehrere Ansteuerübertrager zur galvanisch getrennten Übertragung von Steuersignalen vom Steuerstromkreis auf den PELV-Signalstromkreis umfassen.

Bei einer Ausführungsform sind die Leistungshalbleiter-Schaltelemente der Leistungshalbleiter-Schaltung in einem gemeinsamen oder in mehreren Modulen untergebracht. Durch die ein oder mehreren Module können die Leistungshalbleiter-Schaltelemente vor Verschmutzung geschützt werden. Beispielsweise können die Leistungshalbleiter-Schaltelemente in den ein oder mehreren Modulen mit einer Vergussmasse vergossen sein. Auf diese Weise kann für die Leistungshalbleiter-Schaltelemente lokal beispielsweise ein Verschmutzungsgrad 1 angenommen werden, was in Bezug auf die Isolationskoordination eine Bemessung mit deutlich kleineren Kriechstrecken erlaubt, während die ein oder mehreren Module in ihrer Gesamtheit jeweils die Anforderungen für den Verschmutzungsgrad 3 erfüllen.

Bei einer Ausführungsform sind die Gate-Treiber-Schaltung und/oder die Leistungshalbleiter-Schaltelemente diskret aufgebaut, insbesondere auf einer gemeinsamen Leiterplatte. Beispielsweise können die Gate-Treiber-Schaltung und/oder die Leistungshalbleiter-Schaltelemente auf einer Primärleiterplatte angeordnet sein, auf der elektronische Komponenten des Leistungsstromkreises untergebracht sind.

Bei einer Ausführungsform ist mindestens einer der ein oder mehreren Leistungshalbleiter-Schaltelemente als Wide-Bandgap-Leistungshalbleiter-Schaltelement ausgebildet. Insbesondere können mehrere oder sämtliche der Leistungshalbleiter-Schaltelemente als Wide-Bandgap-Leistungshalbleiter-Schaltelemente ausgebildet sein.

Ein Wide-Bandgap-Leistungshalbleiter-Schaltelement basiert auf einem Wide-Bandgap-Halbleiter. Insbesondere basiert ein Transistor, beispielsweise Feldeffekttransistor oder Bipolartransistor, eines Wide-Bandgap-Leistungshalbleiter-Schaltelements auf einem Wide-Bandgap-Halbleiter.

Ein Wide-Bandgap-Halbleiter ist ein Halbleiter mit einer Bandlücke zwischen Valenz- und Leitungsband von mindestens 3 eV. Bei dem Wide-Bandgap-Halbleiter kann es sich insbesondere um SiC oder GaN handeln. Entsprechend kann das Leistungshalbleiter-Schaltelement insbesondere einen SiC-Transistor oder GaN-Transistor aufweisen. Bei dem SiC- oder GaN-Transistor kann es sich insbesondere um einen MOSFET oder um einen IGBT handeln.

Mit einem Wide-Bandgap-Leistungshalbleiter-Schaltelement können steilere Schaltflanken bzw. schnellere Schaltzeiten und dadurch höhere Taktfrequenzen erreicht werden. Auf diese Weise kann der Schweißstrom auf kürzeren Zeitskalen gesteuert und die Leistungsdichte, insbesondere aufgrund der möglichen Miniaturisierung des Leistungstransformators, erhöht werden.

Bei einer Ausführungsform ist für mindestens einen, vorzugsweise jeden, der ein oder mehreren Treiberausgänge ein zugehöriger Miller-Clamp-Anschluss vorgesehen, der mit dem Gate-Anschluss des zugehörigen Leistungshalbleiter-Schaltungselements verbunden ist. Vorzugsweise ist der Miller-Clamp-Anschluss unmittelbar, insbesondere ohne zwischengeschaltete elektronische Bauelemente, mit dem Gate-Anschluss verbunden. Die Verbindung des Gate-Anschlusses mit dem Miller-Clamp-Anschluss stellt eine gesonderte niederohmige Verbindung zwischen dem Gate-Anschluss und der Gate-Treiber-Schaltung her. Die Gate-Treiber-Schaltung ist insbesondere dazu eingerichtet, den Miller-Clamp-Anschluss auf das Potential des zugehörigen Treiberausgangs zu schalten.

Auf diese Weise können beim schnellen Schalten eines Leistungshalbleiter-Schaltelements durch den Millereffekt am Gate-Anschluss eines anderen der Leistungshalbleiter-Schaltelemente auftretende Spannungsspitzen reduziert und damit ein unerwünschtes Schalten dieser anderen Leistungshalbleiter-Schaltelemente verhindert werden, da die Spannung am Gate-Anschluss des anderen Leistungshalbleiter-Schaltelements durch die niederohmige Verbindung zur Gate-Treiber-Schaltung über den Miller-Clamp-Anschluss auf dem gewünschten Potential gehalten werden kann. Parasitäre Einstreuungen von Schaltvorgängen anderer Leistungshalbleiter werden auf diese Weise reduziert, wodurch schnellere Schaltzeiten ermöglicht werden.

Diese Ausführungsform ist insbesondere vorteilhaft bei Verwendung eines Wide-Bandgap-Leistungshalbleiter-Schaltelements, da diese besonders schnelle Schaltzeiten und damit besonders steile Schaltflanken ermöglichen, so dass hier das Risiko unerwünschter Schaltvorgänge durch parasitäre Einstreuungen aufgrund des Millereffekts besonders hoch ist. Durch die Verwendung des Miller-Clamps kann dieses Risiko stark reduziert bzw. ausgeschlossen werden.

Bei einer Ausführungsform ist eine Pulserzeugung vorgesehen, wobei die Pulserzeugung dazu eingerichtet ist, ein Schalten der Leistungshalbleiter-Schaltelemente mittels der Gate-Treiber-Schaltung mit einer Schaltfrequenz im Bereich von 20 bis 500 kHz, insbesondere 20 bis 200 kHz, zu bewirken. Vorzugsweise weist die Steuerelektronik die Pulserzeugung auf. Die Pulserzeugung kann beispielsweise einen Oszillator, wie einen Quarzoszillator, umfassen, der eine Betriebsfrequenz der Steuerelektronik vorgibt, sowie optional eine Schaltung und/oder Programmierung der Steuerelektronik, die auf Basis der Betriebsfrequenz die Schaltfrequenz bestimmt, mit der die Steuerelektronik Schaltsignale zum Schalten der Leistungshalbleiter-Schaltelemente ausgibt.

Die höhere Taktfrequenz hat den Vorteil, dass der Wechselanteil des Schweißstroms (sogenannter Rippelstrom) sich dadurch bei gleicher Ausgangsinduktivität reduziert und der Schweißlichtbogen damit ruhiger und stabiler wird, so dass ein besserer Schweißprozess ermöglicht wird.

Weitere Merkmale und Vorteile der Vorrichtung und des Schweißgeräts ergeben sich aus der nachfolgenden Beschreibung von Ausführungsbeispielen, wobei auf die beigefügte Zeichnung Bezug genommen wird.

In der Zeichnung zeigen
- Fig. 1: ein Ausführungsbeispiel des Schweißgeräts in schematischer Darstellung,
- Fig. 2: das Leistungsteil der Schweißstromquelle des Schweißgeräts aus Fig. 1 mit einem Ausführungsbeispiel der Vorrichtung,
- Fig. 3: einen ausschnittsweisen schematischen Schaltplan des Leistungsteils aus Fig. 2 und
- Fig. 4a-b: zwei alternative Ausgestaltungen der Gate-Treiber-Schaltung.

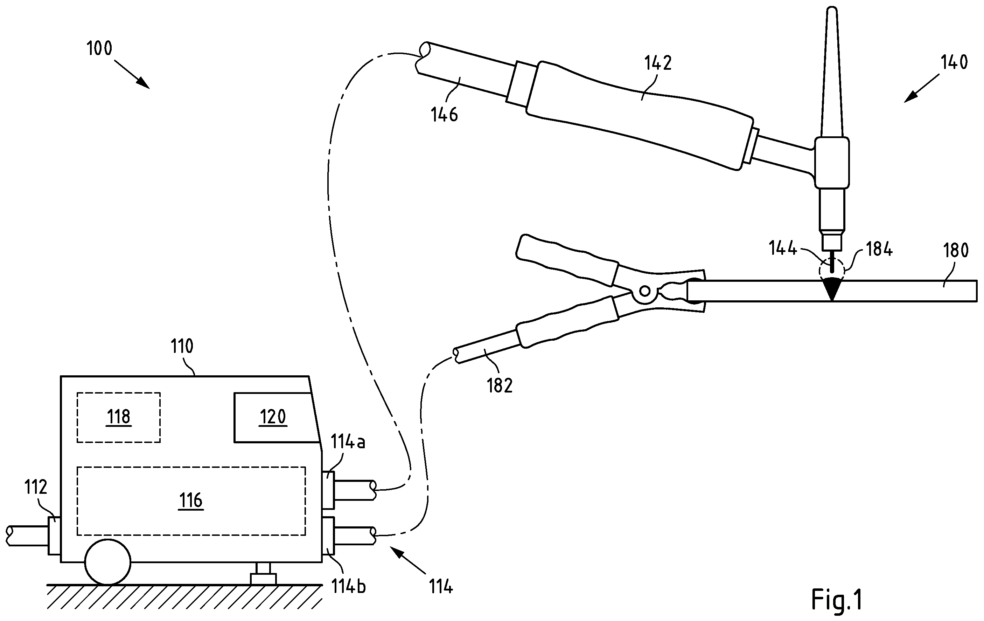

Fig. 1 zeigt ein Ausführungsbeispiel eines Schweißgeräts, nämlich eines Lichtbogenschweißgeräts. Das Lichtbogenschweißgerät 100 ist im vorliegenden Beispiel zum Wolfram-Inertgas-Schweißen (WIG-Schweißen) ausgebildet. Alternativ könnte das Lichtbogenschweißgerät 100 beispielsweise auch zum Metallschutzgas-(MSG)-schweißen, beispielsweise zum Metall-Inertgas-(MIG)- und/oder Metall-Aktivgas-(MAG)-Schweißen, oder zum E-Hand-Schweißen ausgebildet sein.

Das Lichtbogenschweißgerät 100 umfasst eine Schweißstromquelle 110 mit einem Netzanschluss 112 zum Anschließen der Schweißstromquelle 110 an das Stromnetz oder eine andere Spannungsversorgung und mit einem Schweißstromausgang 114, der einen ersten Anschluss 114a für einen Schweißbrenner und einen zweiten Anschluss 114b für eine Werkstückkontaktierung umfasst. Die Schweißstromquelle 110 umfasst weiter ein Leistungsteil 116 zur Bereitstellung eines Schweißstroms, eine Steuereinrichtung 118 zur Steuerung der Schweißstromquelle 110 sowie eine Nutzerschnittstelle 120, über die der Nutzer Betriebsinformationen ablesen und/oder Steuerbefehle eingeben kann. Das Leistungsteil 116 ist dazu eingerichtet, einen Schweißstrom zum Schweißen über die elektrischen Anschlüsse 114a-b der Schweißstromquelle 110 bereitzustellen.

Das Lichtbogenschweißgerät 100 umfasst weiter einen WIG-Schweißbrenner 140, der ein Brennerteil 142 mit einer nicht-abschmelzenden Elektrode 144 und ein Anschlusskabel 146 aufweist. Durch eine Kontaktierung im Brennerteil 142 kann im Betrieb ein über den Anschluss 114a und das Anschlusskabel 146 fließender Schweißstrom auf die Elektrode 144 geleitet werden.

Für den Betrieb wird der WIG-Schweißbrenner 140 mit seinem Anschlusskabel 146 an den ersten Anschluss 114a der Schweißstromquelle 110 angeschlossen. Das zu schweißende Werkstück 180 wird für den Schweißvorgang über ein Werkstückleitung 182 mit dem zweiten Anschluss 114b der Schweißstromquelle 110 verbunden, so dass der elektrische Schweißstromkreis beim Schweißvorgang über die Lichtbogenstrecke 184 zwischen Elektrode 144 und Werkstück 180 geschlossen wird.

Der WIG-Schweißbrenner 140 und die Werkstückleitung 182 stellen Peripherie der Schweißstromquelle 110 dar. Im vorliegenden Ausführungsbeispiel wird diese Peripherie als Teil des Lichtbogenschweißgeräts 100 beschrieben. Alternativ kann auch lediglich die Schweißstromquelle 110 als Lichtbogenschweißgerät angesehen werden, die dann mit separater Peripherie betrieben werden kann.

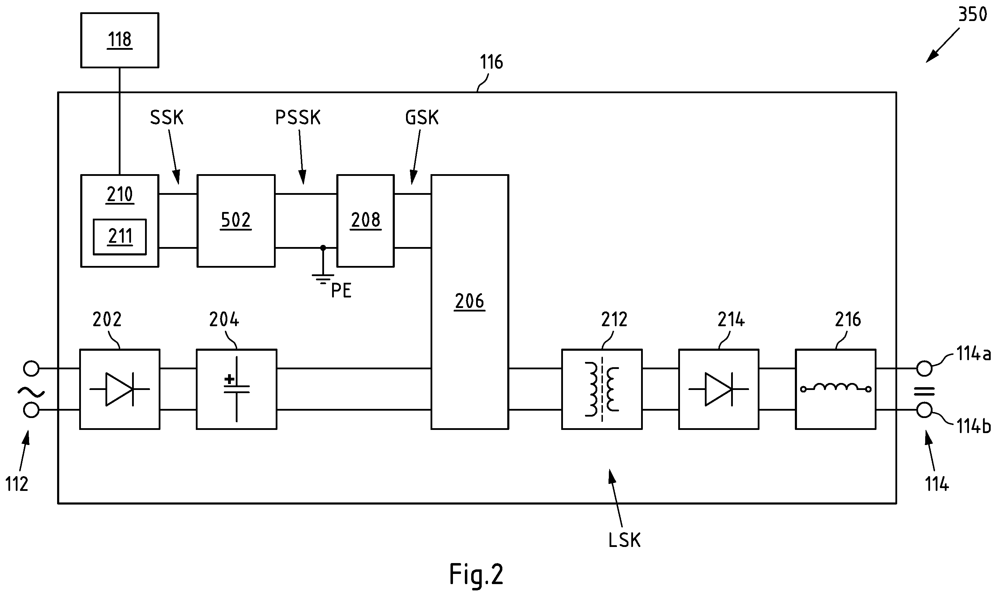

Fig. 2 zeigt das Leistungsteil 116 der Schweißstromquelle 110 in schematischer Blockdarstellung. Das Leistungsteil 116 umfasst einen Eingangs-Gleichrichter 202, einen Gleichspannungs-Zwischenkreis 204, eine Leistungshalbleiter-Schaltung 206, eine Gate-Treiber-Schaltung 208, eine Steuerelektronik 210, einen Transformator 212, einen Ausgangs-Gleichrichter 214 und eine Ausgangsdrossel 216.

Der Eingangs-Gleichrichter 202 wandelt eine am Netzanschluss 112 anliegende Wechselspannung in Gleichspannung um und speist den Gleichspannungs-Zwischenkreis 204. In Fig. 2 ist exemplarisch ein einphasiger Netzanschluss 112 (mit Anschlüssen für eine Phase und einen Nullleiter) gezeigt. Stattdessen kann zum Beispiel auch ein Netzanschluss 122 für Drehstrom (mit drei Phasen-Anschlüssen und einem Nulleiter-Anschluss) oder für Gleichstrom vorgesehen sein. Bei einem Netzanschluss 122 für Gleichstrom entfällt der Eingangs-Gleichrichter 202.

Der Gleichspannungs-Zwischenkreis 204 dient als Ladungszwischenspeicher, um die mittels der Leistungshalbleiter-Schaltung 206 geschalteten hohen primärseitigen Transformatorströme bereitstellen zu können. Anstelle des Gleichspannungs-Zwischenkreises 204 können zum Beispiel auch geteilte Gleichspannungs-Zwischenkreise vorgesehen sein, die jeweils mit der Leistungshalbleiter-Schaltung 206 verbunden sind. Die Anzahl der in Fig. 2 zwischen dem Gleichspannungs-Zwischenkreises 204 und der Leistungshalbleiter-Schaltung 206 eingezeichneten Verbindungen ist lediglich exemplarisch.

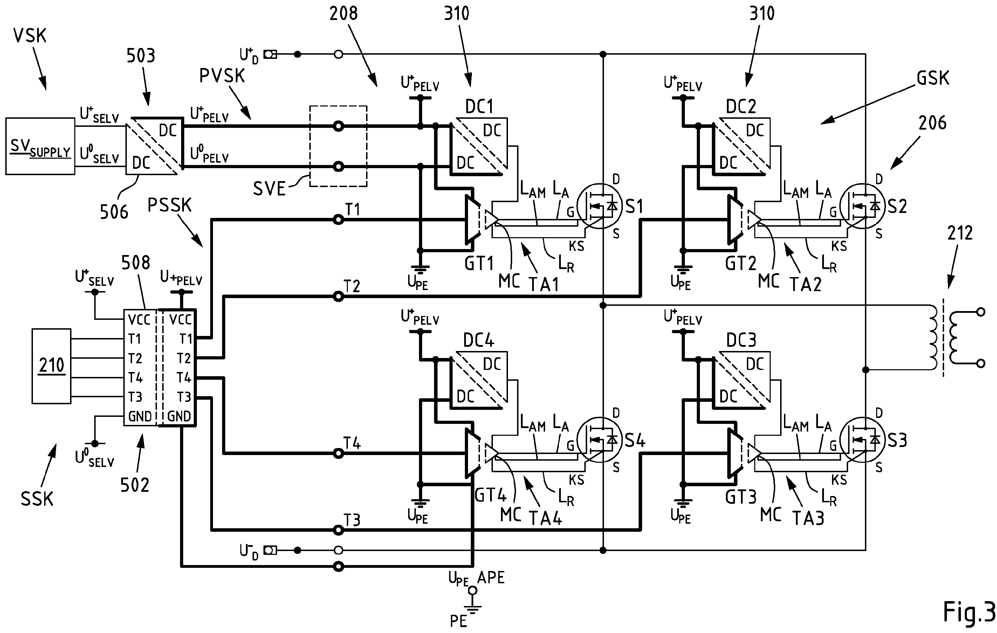

Die Leistungshalbleiter-Schaltung 206 wird durch die Gate-Treiber-Schaltung 208 angesteuert, die wiederum durch die Steuerelektronik 210 gesteuert wird, mit der die Gate-Treiber-Schaltung 208 über eine Signal-Entkoppelungsschaltung 502 mit galvanischer Trennung verbunden ist. Die Steuerelektronik 210 ist vorzugsweise mit der Steuereinrichtung 118 verbunden und kann dadurch durch diese gesteuert, insbesondere parametriert werden. In Fig. 2 sind zwischen der Steuerelektronik 210 und der Signal-Entkoppelungsschaltung 502 bzw. zwischen Signal-Entkoppelungsschaltung 502 und der Gate-Treiber-Schaltung 208 der Übersicht halber lediglich jeweils zwei Verbindungen, nämlich eine jeweilige Steuersignalverbindung (oben) und eine jeweilige Bezugspotential-Verbindung (unten) gezeigt. Tatsächlich verlaufen zwischen der Steuerelektronik 210 und der Signal-Entkoppelungsschaltung 502 bzw. zwischen der Signal-Entkoppelungsschaltung 502 und der Gate-Treiber-Schaltung 208 typischerweise etliche Verbindungen, insbesondere jeweils mindestens eine Verbindung je Steuersignaleingang der Gate-Treiber-Schaltung 208 (s. z.B. Fig. 3).

Der durch die Leistungshalbleiter-Schaltung 206 bereitgestellte primärseitige Transformatorstrom wird weiter durch den Transformator 212 transformiert und durch den Ausgangs-Gleichrichter 214 gleichgerichtet, so dass der Schweißstrom als gesteuerter Gleichstrom über den Schweißstromausgang 114 bereitgestellt wird. In Fig. 2 sind zwischen Leistungshalbleiter-Schaltung 206 und Transformator 212 der Übersicht halber lediglich zwei Verbindungen dargestellt. Stattdessen können auch mehr als zwei Verbindungen vorgesehen sein, beispielsweise drei Leitungen bei Verwendung einer Push-Pull-Topologie.

Im vorliegenden Beispiel ist die Schweißstromquelle 110 als Gleichstrom-Schweißstromquelle ausgebildet. Alternativ kann die Schweißstromquelle 110 auch als Wechselstrom-Schweißstromquelle ausgebildet sein. In diesem Fall kann das Leistungsteil 116 zwischen dem Ausgangs-Gleichrichter 214 und dem Schweißstromausgang 114 noch einen Wechselrichter aufweisen.

Der Stromkreis vom Netzanschluss 112 bis zum Schweißstromausgang 114 stellt einen Leistungsstromkreis LSK der Schweißstromquelle 110 dar.

Das Leistungsteil 116 bildet eine Vorrichtung 350 zur Erzeugung eines Schweißstroms für das Lichtbogenschweißgerät 100 und stellt ein Ausführungsbeispiel der Vorrichtung zur Erzeugung eines Schweißstroms für ein Schweißgerät, insbesondere Lichtbogenschweißgerät, dar.

Fig. 3 zeigt einen ausschnittsweisen möglichen Schaltplan des Leistungsteils 116 der Vorrichtung 350. In dem ausschnittsweisen Schaltplan sind insbesondere die Leistungshalbleiter-Schaltung 206, die Gate-Treiber-Schaltung 208 sowie deren Verbindung mit der Steuerelektronik 210 über die Signal-Entkoppelungsschaltung 502 dargestellt.

Die Leistungshalbleiter-Schaltung 206 weist vier Leistungshalbleiter-Schaltelemente S1 - S4 auf, die vorliegend jeweils einen SiC-Feldeffekttransistor mit den jeweiligen Anschlüssen Drain (D), Gate (G) und Source (S) umfassen und somit als Wide-Bandgap-Leistungshalbleiter-Schaltelemente ausgebildet sind. Daneben weisen die SiC-Feldeffekttransistoren jeweils noch einen Kelvin-Source-Anschluss (KS) auf. Jeweils antiparallel zu den SiC-Feldeffekttransistoren bildet deren p-n Übergang eine intrinsische Body-Diode.

Die Leistungshalbleiter-Schaltelemente S1 - S4 sind bei der Leistungshalbleiter-Schaltung 206 in Vollbrückenschaltung zwischen den Gleichspannungs-Zwischenkreis 204 (mit den Polen U⁺_{D} und U⁻_{D}) und den Transformator 212 geschaltet. Zu diesem Zweck sind jeweils zwei der Leistungshalbleiter-Schaltelemente, nämlich einerseits die Leistungshalbleiter-Schaltelemente S1 und S4 und andererseits die Leistungshalbleiter-Schaltelemente S2 und S3, in Reihe zwischen die beiden Pole U⁺_{D} und U⁻_{D} des Gleichspannungs-Zwischenkreises 204 geschaltet, wobei ein jeweiliger Zwischenabgriff der in Reihe geschalteten Leistungshalbleiter-Schaltelemente mit einem jeweiligen Anschluss des Transformators 212 verbunden ist.

Die Leistungshalbleiter-Schaltelemente S1 - S4 können zum Beispiel als diskrete elektronische Bauteile auf einer gemeinsamen Leiterplatte montiert sein. Weiterhin ist es denkbar, dass die Leistungshalbleiter-Schaltelemente S1 - S4 in jeweilige Module oder in ein gemeinsames Modul integriert sind.

Die Gate-Treiber-Schaltung 208 umfasst für jedes der Leistungshalbleiter-Schaltelemente S1 - S4 einen jeweiligen Steuersignaleingang T1 - T4, der über die Signal-Entkoppelungsschaltung 502 mit einem entsprechenden Steuerausgang der Steuerelektronik 210 verbunden ist. Die Signal-Entkoppelungsschaltung 502 umfasst zu diesem Zweck einen Signalisolator 508 mit galvanischer Trennung. Der Signalisolator 508 ermöglicht eine Signalübertragung mit galvanischer Trennung von Schaltsignalen der Steuerelektronik 210 zu den Schaltsignaleingängen T1 - T4.

Weiter umfasst die Gate-Treiber-Schaltung 208 einen Spannungsversorgungseingang (SVE), die über eine Versorgungs-Entkopplungsschaltung 503 mit galvanischer Trennung mit einer Gate-Treiber-Spannungsquelle (SV_{SUPPLY}) für Sicherheits-Kleinspannung (SELV) verbunden ist. Die Versorgungs-Entkoppelungsschaltung 503 umfasst im vorliegenden Ausführungsbeispiel einen DC/DC-Wandler 506 mit galvanischer Trennung. Der DC/DC-Wandler 506 wird durch die Gate-Treiber-Spannungsquelle SV_{SUPPLY} gespeist. Bei der Gate-Treiber-Spannungsquelle SV_{SUPPLY} kann es sich - wie im vorliegenden Ausführungsbeispiel der Fall - insbesondere um dieselbe Spannungsquelle handeln, die die Steuerelektronik 210 versorgt. Die Gate-Treiber-Spannungsquelle SV_{SUPPLY} kann beispielsweise ein Netzteil umfassen, das die über den Netzanschluss 112 bereitgestellte Netzspannung in eine Sicherheits-Kleinspannung wandelt. Die von der Gate-Treiber-Spannungsquelle SV_{SUPPLY} bereitgestellten Spannungspotentiale werden in Fig. 3 entsprechend als U⁺_{SELV} bzw. U⁰_{SELV} bezeichnet. In einem alternativen Ausführungsbeispiel kann zur Versorgung der für die Steuerelektronik 210 auch eine gesonderte Spannungsquelle vorgesehen sein, beispielsweise ein gesondertes Netzteil.

Die Gate-Treiber-Schaltung 208 umfasst für jedes der Leistungshalbleiter-Schaltelemente S1 - S4 einen Gate-Treiber mit galvanischer Trennung (GT1 - GT4), der im vorliegenden Ausführungsbeispiel einen jeweiligen Signalisolator mit galvanischer Trennung aufweist. Ein solcher Signalisolator ermöglicht die Übertragung von Schaltsignalen von einem Signaleingang des Signalisolators zu einem Signalausgang des Signalisolators mit galvanischer Trennung zwischen Signaleingang und Signalausgang.

Die in Fig. 3 jeweils linke Seite der Gate-Treiber GT1 - GT4 stellt die jeweilige Eingangsseite und die in Fig. 3 jeweils rechte Seite die Ausgangsseite des betreffenden Gate-Treibers GT1 - GT4 dar. Für jedes der Leistungshalbleiter-Schaltelemente S1 - S4 ist der zugehörige Steuersignaleingang T1 - T4 mit dem Signaleingang an der Eingangsseite des zugehörigen Gate-Treibers GT1 - GT4 und der Signalausgang an der Ausgangsseite des zugehörigen Gate-Treibers GT1 - GT4 über eine Ansteuerleitung L_{A} mit dem jeweiligen Gate-Anschluss G des jeweiligen Leistungshalbleiter-Schaltelementes S1 - S4 verbunden. In die Ansteuerleitung L_{A} können zur genaueren und/oder schnelleren Ansteuerung der Wide-Bandgap-Schaltelemente, im vorliegenden Beispiel der SiC-Feldeffekttransistoren, elektronische Bauelemente, wie zum Beispiel Widerstände oder Kondensatoren, integriert sein. Diese sind in Fig. 3 der Übersicht halber nicht dargestellt.

Die Gate-Treiber GT1 - GT4 weisen neben dem jeweiligen Signalausgang vorzugsweise jeweils noch einen Miller-Clamp-Anschluss MC auf, der über eine Miller-Ansteuerleitung L_{AM} parallel zur Ansteuerleitung L_{A} mit dem Gate-Anschluss G verbunden ist. Anders als die Ansteuerleitung L_{A} sind in die Miller-Ansteuerleitung L_{AM} keine elektronischen Bauelemente integriert, so dass über die Miller-Ansteuerleitung L_{AM} und den Miller-Clamp-Anschluss MC eine möglichst niederohmige Verbindung zwischen dem jeweiligen Gate-Anschluss G und dem jeweiligen der Gate-Treiber GT1 - GT4 zur Verfügung steht, über die der Gate-Anschluss G außerhalb von Schaltvorgängen an dem betreffenden Leistungshalbleiter-Schaltelement S1 - S4 auf einem festen Potential, beispielsweise Basispotential, festgehalten werden kann.

Weiter weisen die Gate-Treiber GT1 - GT4 auf der Ausgangsseite jeweils einen Basispotential-Anschluss auf, mit dem der Kelvin-Source-Anschluss KS des jeweiligen Leistungshalbleiter-Schaltelements S1 - S4 über eine jeweilige Ansteuerrückleitung L_{R} verbunden ist.

Der Signalausgang und der Basispotential-Anschluss eines jeweiligen Gate-Treibers GT1 - GT4 stellen einen jeweiligen Treiberausgang TA1 - TA4 der Gate-Treiber-Schaltung 208 dar.

Die Gate-Treiber-Schaltung 208 umfasst weiter für jedes der Leistungshalbleiter-Schaltelemente S1 - S4 eine Gate-Treiber-Spannungsversorgung 310 mit einem jeweiligen DC/DC-Wandler mit galvanischer Trennung (DC1 - DC4). Die in Fig. 3 jeweils linke Seite der DC/DC-Wandler stellt die Eingangsseite und die in Fig. 3 jeweils rechte Seite der DC/DC-Wandler stellt die Ausgangsseite der jeweiligen Gate-Treiber-Spannungsversorgung 310 dar.

Die jeweiligen DC/DC-Wandler sind an ihrer Eingangsseite jeweils mit dem Spannungsversorgungseingang SVE verbunden und stellen an ihrer Ausgangsseite eine jeweilige von dem Spannungsversorgungseingang SVE galvanisch getrennte Versorgungsspannung zur Versorgung des ausgangsseitigen Teils des jeweiligen Gate-Treibers GT1 - GT4 und insbesondere die für die Ansteuerung des jeweiligen Leistungshalbleiter-Schaltelements S1 - S4 erforderliche Spannung bzw. den dafür erforderlichen Strom zur Verfügung. Die Versorgung des jeweiligen Gate-Treibers GT1 - GT4 durch den jeweiligen DC/DC-Wandler ist in Fig. 3 der Übersicht halber durch eine Verbindung symbolisiert.

Die Gate-Treiber-Spannungsversorgungen 310 sind vorliegend als Teil der Gate-Treiber-Schaltung 208 ausgebildet und können zum Beispiel auf derselben Leiterplatte angeordnet sein wie die übrigen Komponenten der Gate-Treiber-Schaltung 208.

Durch die galvanische Trennung in den Gate-Treibern GT1 - GT2 sind die einzelnen Treiberausgänge TA1 - TA4 jeweils von den Steuersignaleingängen T1 - T4 getrennt. Es ergeben sich auf diese Weise jeweils zwei galvanisch voneinander getrennte Stromkreise, nämlich zum einen ein (PELV-)Signalstromkreis PSSK mit der Eingangsseite der Gate-Treiber GT1 - GT4 sowie ein Gate-Ansteuerstromkreis GSK (Primär-Spannungsbereich) mit der Ausgangsseite der Gate-Treiber GT1 - GT4. Der (PELV-)Signalstromkreis PSSK und der Gate-Ansteuerstromkreis GSK sind in Fig. 3 zur Verdeutlichung mit unterschiedlich dicken Linien gezeichnet (dicke Linien: (PELV-)Steuerstromkreis PSSK, dünne Linien: Gate-Ansteuerstromkreis GSK).

Demnach wird auf diese Weise insbesondere eine galvanische Trennung der Steuersignaleingänge von den Treiberausgängen und von der Leistungshalbleiter-Schaltung bewirkt, so dass an den Steuersignaleingängen T1 - T4 bzw. an der Steuerelektronik 210 keine Primär-Spannungen anliegen.

Durch die weitere galvanische Trennung im Signalisolator 508 ist der Signalstromkreis PSSK zudem galvanisch von dem Steuerstromkreis SSK der Steuerelektronik 210 entkoppelt. Weiter ist das Bezugspotential (U⁰_{PELV}) des auf diese Weise beidseitig galvanisch entkoppelten Signalstromkreises PSSK mit einem PE-Anschluss (APE) zum Anschluss an den Schutzleiter PE der Schweißstromquelle 110 verbunden, so dass es sich bei dem Signalstromkreis PSSK um einen PELV-Signalstromkreis (PELV-Potentiale U⁺_{PELV}, U⁰_{PELV}) handelt.

Darüber hinaus sind die Treiberausgänge TA1 - TA4 durch die galvanische Trennung in den DC/DC-Wandlern DC1 - DC4 auch vom Spannungsversorgungseingang SVE getrennt, so dass sich auf diese Weise weiter ein vom jeweiligen Gate-Ansteuerstromkreis GSK getrennter Versorgungsstromkreis PVSK mit der jeweiligen Eingangsseite der Gate-Treiber-Spannungsversorgungen 310, d.h. der Eingangsseite der DC/DC-Wandler DC1 - DC4, ergibt. Die jeweilige Ausgangsseite der Gate-Treiber-Spannungsversorgungen 310, d.h. der DC/DC-Wandler DC/DC-Wandler DC1 - DC4, gehört zum jeweiligen Gate-Ansteuerstromkreis GSK.

Durch die weitere galvanische Trennung im DC/DC-Wandler 506 der Versorgungs-Entkoppelungsschaltung 503 ist der Versorgungsstromkreis PVSK zudem galvanisch von einem weiteren (PELV-)Versorgungsstromkreis VSK der Gate-Treiber-Spannungsquelle SV_{SUPPLY} entkoppelt. Weiter ist das Bezugspotential (U⁰_{PELV}) des auf diese Weise beidseitig galvanisch entkoppelten (PELV-)Versorgungsstromkreises PVSK mit dem PE-Anschluss (APE) zum Anschluss an den Schutzleiter PE der Schweißstromquelle 110 verbunden, so dass es sich bei dem Versorgungsstromkreis PSVK um einen PELV-Versorgungsstromkreis (PELV-Potentiale U⁺_{PELV}, U⁰_{PELV}) handelt.

Die Leitungen in der Gate-Treiber-Schaltung zum PE-Anschluss APE bzw. vom PE-Anschluss APE zum Schutzleiter PE der Schweißstromquelle 110 sind derart dimensioniert, um eine Schutzerdung des PELV-Signalstromkreises PSSK bzw. PELV-Versorgungsstromkreises PVSK bewirken zu können. Insbesondere sind diese Leitungen derart ausgelegt, um in einem Fehlerfall in der galvanischen Trennung in einem der DC/DC-Wandler DC1 - DC4 bzw. Gate-Treiber GT1 - GT4 den im Gate-Ansteuerstromkreis GSK fließenden Strömen entsprechende Fehlerströme, zum Beispiel Stoßströme von ca. 10 kA, zum PE-Anschluss APE tragen zu können, insbesondere zum Schutzleiter PE der Schweißstromquelle 110 ableiten zu können. Zu diesem Zweck kann der PE-Anschluss APE zum Beispiel über eine Verschraubung oder Befestigungsbolzen einer Leiterplatte, auf der die Gate-Treiber-Schaltung angeordnet ist, in der Schweißstromquelle 110, zum Beispiel über das Gehäuse der Schweißstromquelle 110, mit dem Schutzleiter PE der Schweißstromquelle 110 verbunden sein.

Damit sind die Steuersignaleingänge T1 - T4 der Gate-Treiber-Schaltung mit dem PELV-Signalstromkreis PSSK und weiter die Gate-Treiber-Spannungsversorgungsschaltungen 310 mit dem PELV-Versorgungsstromkreis PVSK verbunden.

Auf diese Weise kann selbst bei Versagen einer der beiden galvanischen Entkopplungen des PELV-Signalstromkreises PSSK oder einer der beiden galvanischen Entkopplungen des PELV-Versorgungsstromkreises PVSK weiterhin eine galvanische Entkopplung zwischen Leistungshalbleiter-Schaltung 206 und Steuerelektronik 210 bzw. Gate-Treiber-Versorgungsspannungsquelle SV_{SELV} aufrechterhalten werden, wobei Fehlerströme sicher über den PE-Schutzleiter abgeleitet werden. Auf diese Weise können zum Beispiel die Isolationen in den DC/DC-Wandlern DC1 - DC4 der Gate-Treiber-Spannungsversorgungen 310 und in den Gate-Treibern GT1 - GT4 als einfache Isolierungen ausgeführt werden, wodurch Kosten durch die Verwendbarkeit einfacherer elektronischer Bauteile reduziert werden können. Zudem kann auf diese Weise eine höhere Betriebssicherheit erreicht werden, die auch im Versagensfall gewährleistet bleibt.

Der PELV-Signalstromkreis PSSK und der PELV-Versorgungsstromkreis PVSK können elektrisch miteinander verbunden sein, d.h. es kann sich um denselben PELV-Stromkreis handeln. Weiter kann die Gate-Treiber-Spannungsquelle SV_{SUPPLY}, wie im Ausführungsbeispiel in Fig. 3 der Fall, auch als Spannungsquelle für den Steuerstromkreis SSK bzw. die Steuerelektronik 210 dienen. In einem alternativen Ausführungsbeispiel kann für den Steuerstromkreis SSK bzw. die Steuerelektronik 210 auch eine gesonderte Spannungsquelle vorgesehen sein.

Im Betrieb sendet die Steuerelektronik 210 über den Signalisolator 508 Steuersignale an die Steuersignaleingänge T1 - T4 zur Ansteuerung der einzelnen Leistungshalbleiter-Schaltelemente S1 - S4. Die Gate-Treiber-Schaltung 208 steuert sodann die Leistungshalbleiter-Schaltelemente S1 - S4 über die jeweiligen Gate-Anschlüsse G entsprechend an, wobei die Leistung für die Ansteuerung über die Gate-Treiber-Spannungsversorgungen 310 bereit gestellt wird. Die Schaltfrequenz, mit der die Steuerelektronik 210 die Gate-Treiber-Schaltung 208 und die Gate-Treiber-Schaltung 208 entsprechend die Leistungshalbleiter-Schaltelemente S1 - S4 ansteuert, wird von einer Pulserzeugung 211 in der Steuerelektronik 210 vorgegeben. Die Pulserzeugung 211 kann beispielsweise einen Quarzoszillator umfassen, der die Betriebsgrundfrequenz der Steuerelektronik 210 vorgibt, sowie eine Schaltung und/oder Programmierung innerhalb der Steuerelektronik 210, durch die die Schaltfrequenz basierend auf der Betriebsgrundfrequenz festgelegt wird. Vorzugsweise liegt die Schaltfrequenz im Bereich 20 - 500 kHz, insbesondere 20 - 200 kHz.

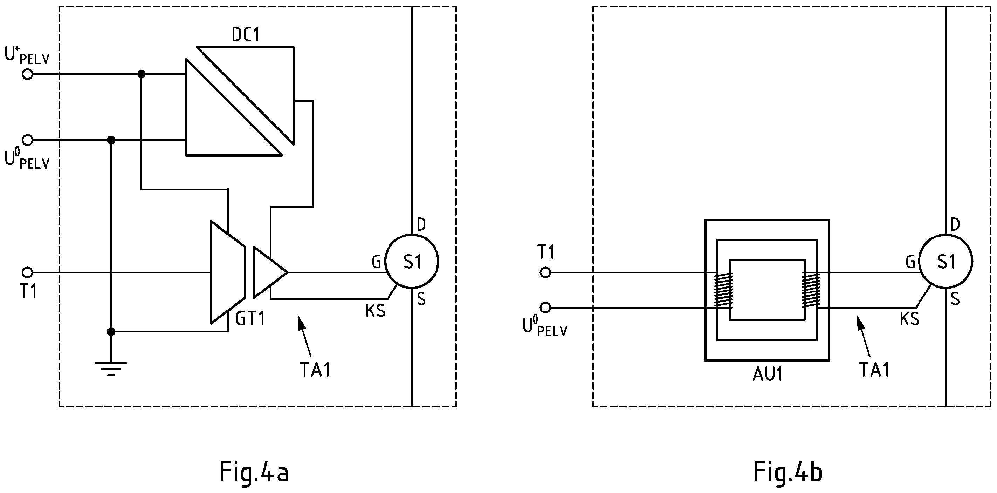

Die Fig. 4a-b illustrieren zwei alternative Ausgestaltungen der Gate-Treiber-Schaltung 208 als schematische ausschnittsweise Schaltpläne.

Fig. 4a zeigt exemplarisch den Gate-Treiber GT1 und den DC-DC-Wandler DC1 der Gate-Treiber-Spannungsversorgung 310 für den Gate-Treiber GT1 aus Fig. 3. Wie im Kontext von Fig. 3 erläutert, werden Steuersignale über den Signalisolator des Gate-Treibers GT1 und die zur entsprechenden Ansteuerung des Gates des Leistungshalbleiter-Schaltelements S1 erforderliche Leistung, insbesondere die dazu erforderlichen hohen Steuerströme, über die gesonderte Gate-Treiber-Spannungsversorgung 310 durch den DC-DC-Wandler DC1 übertragen.

Fig. 4b illustriert eine alternative Ausgestaltung, die bei der Schweißstromquelle 310 anstelle der in Fig. 4a gezeigten Konfiguration verwendet werden kann. Die Gate-Treiber der Gate-Treiber-Schaltung weisen bei dieser alterativen Ausgestaltung anstelle des Signalisolators und des DC-DC-Wandlers einen jeweiligen Ansteuerübertrager auf. Fig. 4b zeigt exemplarisch den Ansteuerübertrager AU1 des Gate-Treibers GT1. Die übrigen Gate-Treiber GT2-4 weisen entsprechende Ansteuerübertrager AU2, AU3 bzw. AU4 auf.

Der Ansteuerübertrager AU1 weist zwei oder mehr über einen Magnetwerkstoff gekoppelte Wicklungen auf, die zumindest teilweise elektrisch voneinander isoliert sind. Beispielsweise kann es sich dabei um einen Ferritkern mit einer Primärwicklung auf Seiten des Signaleingangs T1 und einer Sekundärwicklung auf Seiten des Treiberausgangs TA1 handeln. Mit den über den Signaleingang T1 übermittelten Steuersignalen (PELV-Potential U⁺_{PELV}) wird über den Ansteuerübertrager AU1 auch die zur Ansteuerung des Leistungshalbleiter-Schaltelements S1 erforderliche Leistung übertragen.

Die Ausgestaltung in Fig. 4b ermöglicht einen simpleren Aufbau der Gate-Treiber-Schaltung 208. Demgegenüber können mit der Ausgestaltung aus Fig. 4a schnellere Schaltzeiten und steilere Schaltflanken erreicht werden.

### Bezugszeichenliste:

- 100: Lichtbogenschweißgerät
- 110: Schweißstromquelle
- 112: Netzanschluss
- 114: Schweißstromausgang
- 114a: erster Anschluss des Schweißstromausgangs
- 114b: zweiter Anschluss des Schweißstromausgangs
- 116: Leistungsteil
- 118: Steuereinrichtung
- 120: Nutzerschnittstelle
- 140: Schweißbrenner
- 142: Brennerteil
- 144: Elektrode
- 146: Anschlusskabel
- 180: Werkstück
- 182: Werkstückleitung
- 184: Lichtbogenstrecke
- 202: Gleichrichter
- 204: Zwischenkreis
- 206: Leistungshalbleiter-Schaltung
- 208: Gate-Treiber-Schaltung
- 210: Steuerelektronik
- 211: Pulserzeugung
- 212: Transformator
- 214: Ausgangs-Gleichrichter
- 216: Ausgangsdrossel
- 310: Gate-Treiber-Spannungsversorgung
- 350: Vorrichtung
- 502: Signal-Entkoppelungsschaltung
- 503: Versorgungs-Entkoppelungsschaltung
- 506: DC/DC-Wandler
- 508: Signalisolator
- APE: PE-Anschluss
- AU1, AU2, AU3, AU4: Ansteuerübertrager
- D: Drain-Anschluss
- DC1, DC2, DC3, DC4: DC/DC-Wandler mit galvanischer Trennung
- G: Gate-Anschluss
- GSK: Gate-Ansteuerstromkreis
- GT1, GT2, GT3, GT4: Gate-Treiber mit galvanischer Trennung
- KS: Kelvin-Source-Anschluss
- L_{A}: Ansteuerleitung
- L_{AM}: Miller-Ansteuerleitung
- L_{R}: Ansteuerrückleitung
- LSK: Leistungsstromkreis
- MC: Miller-Clamp-Anschluss
- PE: Schutzleiter
- PSSK: PELV-Steuerstromkreis
- PVSK: PELV-Versorgungsstromkreis
- S: Source-Anschluss
- S1, S2, S3, S4: Leistungshalbleiter-Schaltelement
- SSK: Steuerstromkreis
- SVE: Spannungsversorgungseingang
- SV_{SUPPLY}: Gate-Treiber-Spannungsquelle
- T1, T2, T3, T4: Steuersignaleingang
- TA1, TA2, TA3, TA4: Treiberausgang

## Patentansprüche

1. Vorrichtung (350) zur Erzeugung eines Schweißstroms für ein Schweißgerät (100), insbesondere Lichtbogenschweißgerät,
- mit einer Leistungshalbleiter-Schaltung (206) umfassend ein oder mehrere Leistungshalbleiter-Schaltelemente (S1, S2, S3, S4) und
- mit einer Gate-Treiber-Schaltung (208), die ein oder mehrere Steuersignaleingänge (T1, T2, T3, T4) zum Empfang von elektrischen Steuersignalen und ein oder mehrere Treiberausgänge (TA1, TA2, TA3, TA4) zum elektrischen Ansteuern der ein oder mehreren Leistungshalbleiter-Schaltelemente (S1, S2, S3, S4) aufweist und dazu eingerichtet ist, die Leistungshalbleiter-Schaltelemente (S1, S2, S3, S4) abhängig von über die ein oder mehreren Steuersignaleingänge (T1, T2, T3, T4) empfangenen elektrischen Steuersignalen elektrisch anzusteuern,
- wobei die Gate-Treiber-Schaltung (208) so ausgebildet ist, dass die ein oder mehreren Steuersignaleingänge (T1, T2, T3, T4) von den ein oder mehreren Treiberausgängen (TA1, TA2, TA3, TA4) galvanisch getrennt sind,
**dadurch gekennzeichnet,**
- **dass** die ein oder mehreren Steuersignaleingänge (T1, T2, T3, T4) der Gate-Treiber-Schaltung (208) mit einem PELV-Signalstromkreis (PSSK) verbunden sind.

2. Vorrichtung nach Anspruch 1,
**dadurch gekennzeichnet, dass** der PELV-Signalstromkreis (PSSK) über eine Signal-Entkoppelungsschaltung (502) mit einem Steuerstromkreis (SSK) gekoppelt ist, so dass Steuersignale von dem Steuerstromkreis (SSK) auf den PELV-Signalstromkreis (PSSK) übertragen werden können, wobei die Signal-Entkoppelungsschaltung (502) den PELV-Signalstromkreis (PSSK) und den Steuerstromkreis (SSK) voneinander galvanisch trennt.

3. Vorrichtung nach Anspruch 1 oder 2,
**dadurch gekennzeichnet, dass** die Gate-Treiber-Schaltung (208) ein oder mehrere Gate-Treiber (GT1, GT2, GT3, GT4) aufweist, die jeweils dazu eingerichtet sind, die Ansteuerung von mindestens einem der ein oder mehreren Leistungshalbleiter-Schaltelemente (S1, S2, S3, S4) über einen der Treiberausgänge (TA1, TA2, TA3, TA4) abhängig von über mindestens einen der ein oder mehreren Steuersignaleingänge (T1, T2, T3, T4) erhaltenen Steuersignalen zu bewirken.

4. Vorrichtung nach Anspruch 3,
**dadurch gekennzeichnet, dass** die ein oder mehreren Gate-Treiber (GT1, GT2, GT3, GT4) einen jeweiligen Signalisolator zur galvanisch getrennten Übertragung von über einen jeweiligen Steuersignaleingang (T1, T2, T3, T4) erhaltenen Steuersignalen aufweisen und dazu eingerichtet sind, die zur Ansteuerung eines jeweiligen der Leistungshalbleiter-Schaltelemente (S1, S2, S3, S4) verwendete elektrische Leistung zumindest teilweise über eine vom Signalisolator separate Gate-Treiber-Spannungsversorgungsschaltung (310) zu erhalten.

5. Vorrichtung nach einem der Ansprüche 1 bis 4,
**dadurch gekennzeichnet, dass** die Vorrichtung (350) ein oder mehrere Gate-Treiber-Spannungsversorgungsschaltungen (310) aufweist.

6. Vorrichtung nach einem der Ansprüche 4 oder 5,
**dadurch gekennzeichnet, dass** die ein oder mehreren Gate-Treiber-Spannungsversorgungsschaltungen (310) mit einem PELV-Versorgungsstromkreis (PVSK) verbunden sind.

7. Vorrichtung nach Anspruch 6,
**dadurch gekennzeichnet, dass** der PELV-Versorgungsstromkreis (PVSK) über eine Versorgungs-Entkoppelungsschaltung (503) mit einer Gate-Treiber-Spannungsquelle (SV_{SUPPLY}) gekoppelt ist, wobei die Versorgungs-Entkoppelungsschaltung (503) den PELV-Versorgungsstromkreis (PVSK) und die Gate-Treiber-Spannungsquelle (SV_{SUPPLY}) voneinander galvanisch trennt.

8. Vorrichtung nach einem der Ansprüche 1 bis 3,
**dadurch gekennzeichnet, dass** die ein oder mehreren Gate-Treiber (GT1, GT2, GT3, GT4) einen jeweiligen Ansteuerübertrager (AU1, AU2, AU3, AU4) zur galvanisch getrennten Übertragung von über einen jeweiligen Steuersignaleingang (T1, T2, T3, T4) erhaltenen Steuersignalen aufweisen und dazu eingerichtet sind, die zur Ansteuerung eines jeweiligen der Leistungshalbleiter-Schaltelemente (S1, S2, S3, S4) verwendete elektrische Leistung über die Ansteuerübertrager (AU1, AU2, AU3, AU4) bereitzustellen.

9. Vorrichtung nach einem der Ansprüche 1 bis 8,
**dadurch gekennzeichnet, dass** die Leistungshalbleiter-Schaltelemente (S1, S2, S3, S4) der Leistungshalbleiter-Schaltung (206) in einem gemeinsamen oder in mehreren Modulen untergebracht sind.

10. Vorrichtung nach einem der Ansprüche 1 bis 8,
**dadurch gekennzeichnet, dass** die Gate-Treiber-Schaltung und/oder die Leistungshalbleiter-Schaltelemente diskret aufgebaut sind, insbesondere auf einer gemeinsamen Leiterplatte.

11. Vorrichtung nach einem der Ansprüche 1 bis 10,
**dadurch gekennzeichnet, dass** mindestens einer der ein oder mehreren Leistungshalbleiter-Schaltelemente (S1, S2, S3, S4) als Wide-Bandgap-Leistungshalbleiter-Schaltelement ausgebildet ist.

12. Vorrichtung nach einem der Ansprüche 1 bis 11,
**dadurch gekennzeichnet, dass** für mindestens einen der ein oder mehreren Treiberausgänge (TA1, TA2, TA3, TA4) ein zugehöriger Miller-Clamp-Anschluss (MC) vorgesehen ist, der mit dem Gate-Anschluss (G) des zugehörigen Leistungshalbleiter-Schaltungselements (S1, S2, S3, S4) verbunden ist.

13. Vorrichtung nach einem der Ansprüche 1 bis 12,
**dadurch gekennzeichnet, dass** eine Pulserzeugung (211) vorgesehen ist, wobei die Pulserzeugung (211) dazu eingerichtet ist, ein Schalten der Leistungshalbleiter-Schaltelemente (S1, S2, S3, S4) mittels der Gate-Treiber-Schaltung (208) mit einer Schaltfrequenz im Bereich von 20 bis 500 kHz zu bewirken.

14. Schweißgerät (100), insbesondere Lichtbogenschweißgerät, aufweisend eine Vorrichtung (350) nach einem der Ansprüche 1 bis 13.
